# EUROPÄISCHE PATENTANMELDUNG

(11) **EP 3 419 063 A1**
(43) Veröffentlichungstag der Anmeldung: **26.12.2018**
(21) Anmeldenummer: 18178603.9
(22) Anmeldetag: 19.06.2018
(51) Int. Cl.: H01L 33/50, G08B 13/24, H05K 1/03, H05K 1/18, F21K 9/64

(54) **FOLIENAUFBAU MIT ERZEUGEN VON SICHTBAREM LICHT MITTELS LED-TECHNOLOGIE**

(30) Priorität: 19.06.2017 DE 102017113375
(71) Anmelder: Schreiner Group GmbH & Co. KG, 85764 Oberschleissheim (DE)
(72) Erfinder: Becker, Johannes, 85304 Ilmmünster (DE); Gepp, Sebastian, 82256 Fürstenfeldbruck (DE); Hartmann, Manfred, 85238 Petershausen (DE); Wiederrecht, Hartmut, 85386 Eching (DE)
(74) Vertreter: Epping - Hermann - Fischer

(57) **Zusammenfassung**

Ein Folienaufbau (1) mit Erzeugen von sichtbarem Licht mittels LED-Technologie umfasst eine Trägerfolie (10) und einen LED-Chip (20) zum Erzeugen von UV-Licht. Der LED-Chip (20) ist auf der Trägerfolie (10) angeordnet und weist eine Lichtaustrittsfläche (21) zum Abstrahlen des UV-Lichts auf. Weiterhin umfasst der Folienaufbau (1) eine Farbreaktionsschicht (30) zum Umwandeln des UV-Lichts in das sichtbare Licht. Die Farbreaktionsschicht (30) ist über dem LED-Chip (20) oder seitlich versetzt zu dem LED-Chip (20) angeordnet. Die Farbreaktionsschicht (30) weist eine Strukturierung auf, so dass das aus der Lichtaustrittsfläche (21) des LED-Chips (20) abgestrahlte UV-Licht nicht in die Umgebung des Folienaufbaus (1) abgestrahlt wird.

## Beschreibung

Die Erfindung betrifft einen Folienaufbau mit Erzeugen von sichtbarem Licht mittels LED-Technologie, wobei das Licht von einer leuchtemittierenden Diode erzeugt wird.

Leuchtemittierende Dioden werden aufgrund ihres kleinen Bauraums und ihres geringen Flächenbedarfs in vielen Anwendungsbereichen zur Beleuchtung von Objekten oder zur Hinterleuchtung von Bedienfeldern eingesetzt. Ein LED-Baustein umfasst üblicherweise einen LED-Chip mit einer Lichtaustrittsfläche. Der LED-Chip ist in einem Gehäuse, beispielsweise einem Kunststoffgehäuse, untergebracht. Viele LED-Chips strahlen Licht im UV- oder UV-nahen Bereich ab. Die Umwandlung des UV-Lichts in sichtbares Licht erfolgt durch eine Reaktionsschicht, die das auf sie auftreffende UV-Licht in sichtbares Licht wandelt. Die Reaktionsschicht ist in dem Gehäuse des LED-Bausteins eingebracht.

LEDs mit Kunststoffgehäuse werden üblicherweise auf einer starren Platine, beispielsweise einem Printed Circuit Board (PCB), angeordnet und verbaut. Je nach Anwendungsfall werden elektronische Schaltungen oftmals auf flexiblen Substraten, beispielsweise auf einer Trägerfolie, angeordnet. Ein LED-Baustein mit Kunststoffgehäuse kann zwar auf einem Foliensubstrat angeordnet werden. Allerdings erfolgt die Platzierung des LED-Bausteins in der Regel nicht maschinell, da Chipbestückungsanlagen zur Bestückung von flexiblen Substraten LED-Bausteine mit Kunststoffgehäuse üblicherweise nicht verarbeiten können. Ein LED-Baustein mit Kunststoffgehäuse kann oft nur manuell auf dem Foliensubstrat befestigt werden. Der Bestückungsprozess ist daher aufwändig. Die Lichtausbeute beziehungsweise Lichtfarbe des von einem LED-Baustein mit Kunststoffgehäuse abgestrahlten Lichts kann des Weiteren nur schwer verändert oder modifiziert werden.

Ein Anliegen der vorliegenden Erfindung ist es, einen Folienaufbau mit Erzeugen von sichtbarem Licht mittels LED-Technologie anzugeben, wobei der Folienaufbau mit geringem Fertigungsaufwand herstellbar ist und die optischen Eigenschaften der LED auf einfache Weise modifiziert werden können.

Eine Ausführungsform eines derartigen Folienaufbaus mit Erzeugen von sichtbarem Licht mittels LED-Technologie ist im Patentanspruch 1 angegeben.

Der Folienaufbau umfasst eine Trägerfolie und einen LED-Chip zum Erzeugen von UV-Licht. UV-Licht bedeutet im Folgenden Licht im Wellenlängenbereich zwischen 1 nm und 480 nm. Der LED-Chip ist auf der Trägerfolie angeordnet und weist eine Lichtaustrittsfläche zum Abstrahlen des UV-Lichts auf. Weiterhin umfasst der Folienaufbau eine Farbreaktionsschicht zum Umwandeln des UV-Lichts in das sichtbare Licht. Die Farbreaktionsschicht ist über dem LED-Chip oder seitlich versetzt zu dem LED-Chip angeordnet. Die Farbreaktionsschicht weist eine Strukturierung auf, so dass das aus der Lichtaustrittsfläche des LED-Chips abgestrahlte UV-Licht nicht in die Umgebung des Folienaufbaus abgestrahlt wird.

Der LED-Chip weist lediglich die Lichtaustrittsfläche zum Austreten des UV-Lichts auf, ist jedoch nicht in einem Kunststoffgehäuse angeordnet. Es handelt sich somit um einen Chip auf Waferbasis, der aus einem Wafer vereinzelt ist. Durch die Verwendung eines solchen LED-Chips lässt sich der Folienaufbau mit dem LED-Chip automatisiert in rotativer Herstellung von Rolle zu Rolle fertigen.

Der Chip als auch die Farbreaktionsschicht können auf unterschiedlichen Abschnitten der Trägerfolie angeordnet sein. Die Trägerfolie kann derart umgefaltet werden, dass der Abschnitt der Trägerfolie mit der Farbreaktionsschicht über einer Lichtaustrittsfläche des Chips oder seitlich versetzt zu der Lichtaustrittsfläche des Chips angeordnet ist. Durch das Falten können weitere elektrische und nicht elektrische Elemente im flachen Zustand erzeugt und anschließend in eine andere Ebene gebracht werden. Zum Beispiel kann eine berührungsempfindliche Fläche näher am Nutzer und eine Lichtquelle dahinter angeordnet werden.

Durch weitere Maßnahmen, wie zum Beispiel durch Kombination verschiedener Phosphorfarben, können neue Mischfarben erzeugt werden. Zusätzlich besteht die Möglichkeit, die Phosphorfarben mit anderen Farben, beispielsweise mit Tageslichtfarben oder opaken Farben, zu kombinieren, um wiederum neue Effekte zu erzielen. Unterschiedliche Farbübergänge können durch Drucken von Phosphorfarben übereinander oder mittels Linien nebeneinander oder als Raster hergestellt werden.

Um die Lichtstreuung und Lichtintensität zu beeinflussen und gegebenenfalls zu homogenisieren, können ebenfalls verschiedene Druckmethoden angewandt werden, bei denen unterschiedliche Schichten übereinander oder nebeneinander gedruckt werden. Beispielsweise können Phosphorfarben in verschiedenen Opazitäten im Rasterdruck als Farbreaktionsschicht auf die Trägerfolie aufgedruckt werden. Die Opazität wird durch die Korngröße, deren Verteilung in der Farbe sowie die gedruckte Schichtdicke eingestellt. Es braucht eine minimale Schichtdicke, beziehungsweise Anzahl an Partikeln, damit der Effekt richtig funktioniert.

Weiterhin sind "mechanische" Möglichkeiten der Lichtleitung beziehungsweise Lichtstreuung gegeben. Beispielsweise können zwischen der Lichtaustrittsfläche des LED-Chips und der Farbreaktionsschicht Folien als Abstandshalter mit unterschiedlichen optischen Effekten eingesetzt werden.

Die Erfindung wird im Folgenden anhand von Figuren, die Ausführungsbeispiele der vorliegenden Erfindung zeigen, näher erläutert. Es zeigen:
Figur 1 eine Ausführungsform eines Folienaufbaus mit Erzeugen von sichtbarem Licht mittels LED-Technologie mit einer umgefalteten Trägerfolie;
Figur 2 eine weitere Ausführungsform eines Folienaufbaus mit Erzeugen von sichtbarem Licht mittels LED-Technologie mit einer separaten Träger-/Deckfolie zum Aufbringen einer Farbreaktionsschicht;
Figur 3 eine weitere Ausführungsform eines Folienaufbaus mit Erzeugen von sichtbarem Licht mittels LED-Technologie mit einer umgefalteten Trägerfolie und einem LED-Chip als Kantenstrahler;
Figur 4 eine weitere Ausführungsform eines Folienaufbaus mit Erzeugen von sichtbarem Licht mittels LED-Technologie mit einer separaten Träger-/Deckfolie und einem LED-Chip als Kantenstrahler;
Figur 5 eine Ausführungsform einer Farbreaktionsschicht mit zwei verschiedenen Lagen zur Erzeugung von Farbübergängen und Mischfarben;
Figur 6A eine Ausgestaltungsform einer Farbreaktionsschicht als punkt- und/oder linienförmiges Raster mit Modulation der Höhe der Punkte und/oder der Linien des Rasters;
Figur 6B eine Ausgestaltungsform der Farbreaktionsschicht als punkt- und/oder linienförmiges Raster mit Modulation der Abstände zwischen den Punkten und/oder Linien des Rasters;
Figur 7 eine Ausgestaltungsform einer Farbreaktionsschicht als punkt- und/oder linienförmiges Raster mit einer eingedruckten opaken Farbe;
Figur 8 eine Ausgestaltungsform einer Farbreaktionsschicht mit einer vollflächigen Lage einer Farbreaktionsschicht und einem gerasterten Aufdruck einer opaken Farbe;
Figur 9 eine Ausgestaltungsform einer Farbreaktionsschicht in Form von linsenförmigen Partikeln;
Figur 10 eine Ausgestaltungsform einer Farbreaktionsschicht mit einer UV-Licht sperrenden Schicht;
Figur 11 eine weitere Ausführungsform eines Folienaufbaus mit Erzeugen von sichtbarem Licht mittels LED-Technologie mit einer Abstandsschicht zwischen einer Lichtaustrittsfläche eines LED-Chips und einer Farbreaktionsschicht; und
Figur 12 eine weitere Ausführungsform eines Folienaufbaus mit Erzeugen von sichtbarem Licht mittels LED-Technologie mit einer Reflektorschicht zur Reflektion des von einem LED-Chip abgestrahlten UV-Lichts.

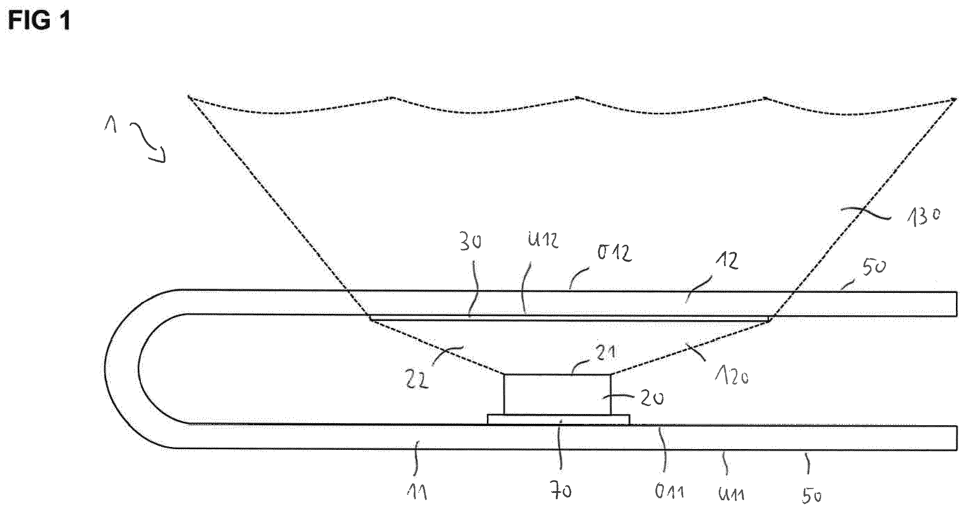

Figur 1 zeigt eine Ausführungsform eines Folienaufbaus 1 mit einer Trägerfolie 10, auf der ein LED-Chip 20 zum Erzeugen von UV-Licht angeordnet ist. Der LED-Chip 20 weist eine Lichtaustrittsfläche 21 zum Abstrahlen des UV-Lichts auf. Der Chip liegt in Waferform vor. Der Chip ist also nicht wie bei einer herkömmlichen LED in einem Kunststoffgehäuse untergebracht. Stattdessen umfasst der LED-Chip 20 nur den Teil des Silizium-Wafers mit der Lichtaustrittsfläche, aus der das UV-Licht abgestrahlt wird, sowie eine Kontaktierung, die an der Ober- oder Unterseite des LED-Chips angeordnet sein kann.

Zum Umwandeln des von dem LED-Chip 20 ausgestrahlten UV-Lichts in sichtbares Licht weist der Folienaufbau 1 eine Farbreaktionsschicht 30 auf. Die Farbreaktionsschicht ist auf der Trägerfolie 10 angeordnet. Die Trägerfolie 10 ist bei der in Figur 1 dargestellten Ausführungsform derart umgefaltet, dass die Farbreaktionsschicht 30 in über dem LED-Chip 20 beziehungsweise über einem Lichtaustrittsbereich 22 der Lichtaustrittsfläche 21 des LED-Chips 20 angeordnet ist. Zumindest Teilbereiche der Farbreaktionsschicht 30 sind in senkrechter Projektion über der Lichtaustrittsfläche 21 des LED-Chips angeordnet.

Der LED-Chip 20 ist auf einem Abschnitt 11 der Trägerfolie 10 angeordnet. Die Farbreaktionsschicht 30 ist auf einem Abschnitt 12 der Trägerfolie 10 angeordnet. Der LED-Chip 20 ist auf einer Oberseite O11 des Abschnitts 11 der Trägerfolie 10 angeordnet. Die Farbreaktionsschicht 30 ist auf einer Unterseite U12 des Abschnitts 12 der Trägerfolie 10, die der Oberseite O11 des Abschnitts 11 der Trägerfolie 10 zugewandt ist, angeordnet. Die in Figur 1 gezeigte Ausführungsform des Folienaufbaus 1 kann auch so modifiziert werden, dass die Farbreaktionsschicht 30 auf einer Oberseite O12 des Abschnitts 12 der Trägerfolie 10, die der Lichtaustrittsfläche 21 des LED-Chips 20 abgewandt ist, angeordnet ist. Die Trägerfolie 10 ist derart umgefaltet, dass der Abschnitt 12 der Trägerfolie 10 über dem Abschnitt 11 der Trägerfolie 10 angeordnet ist.

Bei der in Figur 1 dargestellten Ausführungsform des Folienaufbaus 1 ist die Lichtaustrittsfläche 21 des LED-Chips 20 parallel zu der Fläche des Abschnitts 12 der Trägerfolie 10 angeordnet, auf der auch die Farbreaktionsschicht 30 angeordnet ist. Das von dem LED-Chip 20 aus der Lichtaustrittsfläche 21 abgestrahlte, für das menschliche Auge nicht-sichtbare UV-Licht 120 trifft auf die Farbreaktionsschicht 30 auf und wird von dieser in sichtbares Licht 130 gewandelt. Das sichtbare Licht 130 durchdringt den Abschnitt 12 der Trägerfolie 10 und wird in die Umgebung abgestrahlt. Zumindest der Abschnitt 12 der Trägerfolie 10 ist lichtdurchlässig ausgebildet.

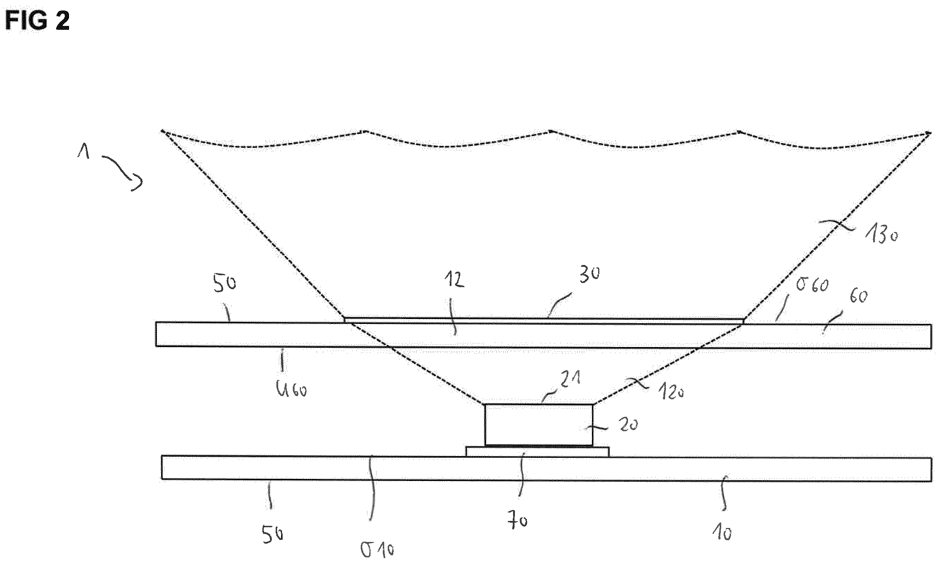

Figur 2 zeigt eine weitere Ausführungsform des Folienaufbaus 1 zum Erzeugen von sichtbarem Licht mittels einer LED-Technologie. Der Folienaufbau umfasst die Trägerfolie 10 sowie den LED-Chip 20 zum Erzeugen von UV-Licht mit der Lichtaustrittsfläche 21 zum Abstrahlen des UV-Lichts 120. Der LED-Chip 20 ist auf einer Oberseite O10 der Trägerfolie 10 angeordnet und strahlt aus der Lichtaustrittsfläche 21 UV-Licht 120 nach oben ab. Zum Umwandeln des UV-Lichts 120 in das sichtbare Licht 130 ist die Farbreaktionsschicht 30 vorgesehen.
Im Unterschied zu der in Figur 1 gezeigten Ausführungsform ist die Farbreaktionsschicht 30 auf einer separaten Träger- beziehungsweise Deckfolie 60 angeordnet. Die Farbreaktionsschicht 30 kann wie bei der in Figur 1 gezeigten Ausführungsform auf einer Unterseite U60 der separaten Trägerfolie 60 angeordnet sein. In Figur 2 ist eine Ausführungsform gezeigt, bei der die Farbreaktionsschicht 30 auf einer Oberseite O60 der separaten Trägerfolie 60 angeordnet ist. Die Oberseite O60 der Trägerfolie 60 ist diejenige Oberfläche der Trägerfolie 60, die der Lichtaustrittsfläche 21 des LED-Chips 20 abgewandt ist.

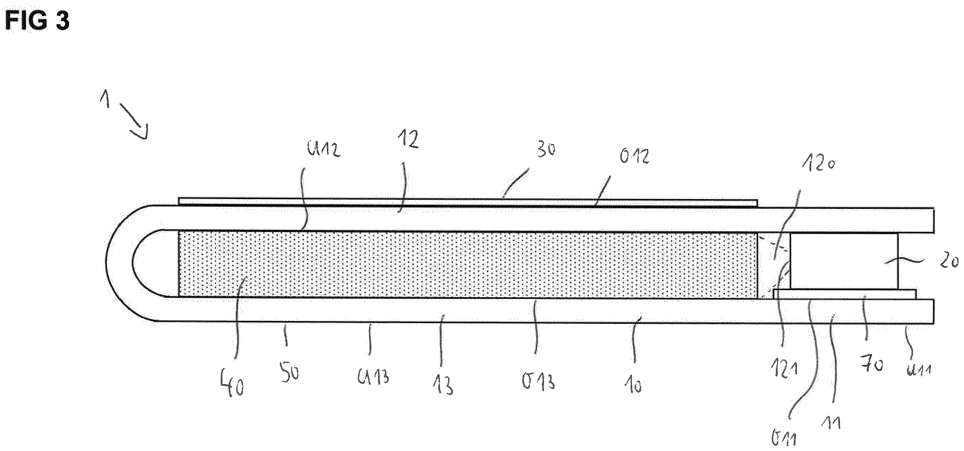

Figur 3 zeigt eine weitere Ausführungsform des Folienaufbaus 1 mit einer Trägerfolie 10, auf der ein LED-Chip 20 zum Erzeugen von UV-Licht angeordnet ist. Der LED-Chip 20 ist auf der Oberseite O11 des Abschnitts 11 der Trägerfolie 10 angeordnet. Der LED-Chip 20 weist die Lichtaustrittsfläche 21 zum Abstrahlen des UV-Lichts auf. Weiterhin umfasst der Folienaufbau 1 die Farbreaktionsschicht 30 zum Umwandeln des UV-Lichts in das sichtbare Licht. Bei der in Figur 3 dargestellten Ausführungsform ist die Farbreaktionsschicht 30 auf dem Abschnitt 12 der Trägerfolie 10, die der Oberseite O11 des Abschnitt 11 der Trägerfolie 10 abgewandt ist, angeordnet. Die Farbreaktionsschicht 30 kann, wie in Figur 3 dargestellt, auf der Oberseite O12 des Abschnitts 12 der Trägerfolie 10 als auch auf der Unterseite U12 des Abschnitts 12 der Trägerfolie 10, die der Oberseite O11 des Abschnitts 11 der Trägerfolie 10 zugewandt ist, angeordnet sein.

Im Unterschied zu der in Figur 1 gezeigten Ausführungsform ist die Trägerfolie 10 derart umgefaltet, dass die Farbreaktionsschicht 30 seitlich versetzt zu dem LED-Chip 20 beziehungsweise seitlich versetzt zu dem Lichtaustrittsbereich 22 der Lichtaustrittsfläche 21 des LED-Chips 20 angeordnet ist. Die Trägerfolie 10 ist derart umgefaltet, dass der Abschnitt 12 der Trägerfolie 10 seitlich versetzt zu dem Abschnitt 11 der Trägerfolie angeordnet ist. Der LED-Chip 20 ist als ein Kantenstrahler ausgebildet. Die Lichtaustrittsfläche 21 des LED-Chips 20 ist dabei senkrecht zu der Fläche des Abschnitts 12 der Trägerfolie 10 angeordnet, auf der auch die Farbreaktionsschicht 30 vorgesehen ist.

Zwischen dem Abschnitt 11 und dem Abschnitt 12 der Trägerfolie ist ein Abschnitt 13 der Trägerfolie angeordnet. Der Folienaufbau gemäß Figur 3 umfasst eine Abstandsschicht 40. Die Abstandsschicht 40 ist zwischen dem Abschnitt 12 und dem Abschnitt 13 der Trägerfolie 10 angeordnet. Bei der in Figur 3 gezeigten Ausführungsform des Folienaufbaus 1 ist der LED-Chip 20 als ein Kantenstrahler ausgebildet und strahlt UV-Licht 120 seitlich aus der Lichtaustrittsfläche 21 in die Abstandsschicht 40 ein. Die Abstandsschicht 40 kann als eine Lichtleiterfolie ausgebildet sein, in der das Licht in Richtung der Farbreaktionsschicht 30 abgelenkt beziehungsweise gestreut wird. Das UV-Licht wird in der Farbreaktionsschicht 30 in sichtbares Licht gewandelt und in die Umgebung abgestrahlt.

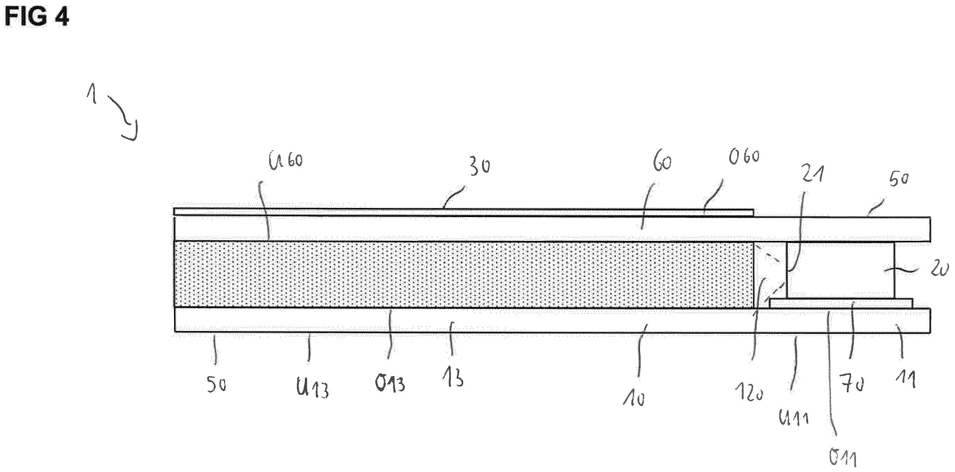

Figur 4 zeigt eine Ausführungsform des Folienaufbaus 1 mit einer Trägerfolie 10, auf der ein LED-Chip 20 angeordnet ist. Über dem LED-Chip 20 ist eine separate Träger- beziehungsweise Deckfolie 60 angeordnet. Der Folienaufbau weist die Farbreaktionsschicht 30 zum Umwandeln des aus der Lichtaustrittsfläche 21 des LED-Chips ausgestrahlten UV-Lichts in sichtbares Licht auf. Die Farbreaktionsschicht 30 ist auf der separaten Träger-/Deckfolie 60 angeordnet. Die Farbreaktionsschicht 30 kann auf einer Unterseite U60 oder einer Oberseite O60 der Träger-/Deckfolie 60 angeordnet sein.

Insbesondere ist die Farbreaktionsschicht 30 seitlich versetzt zu dem LED-Chip 20 beziehungsweise seitlich versetzt zu der Lichtaustrittsfläche 21 des LED-Chips 20 angeordnet. Zwischen dem Abschnitt der Träger-/Deckfolie 60, der seitlich versetzt zu dem LED-Chip 20 angeordnet ist und dem Abschnitt der Trägerfolie 10, der seitlich versetzt zu dem LED-Chip 20 angeordnet ist, ist die Abstandsschicht 40 vorgesehen. Der LED-Chip 20 ist wie bei der in Figur 3 gezeigten Ausführungsform als ein Kantenstrahler ausgebildet. Die Lichtaustrittsfläche 21 des LED-Chips 20 ist parallel zur Normalen auf die Träger-/Deckfolie 60 beziehungsweise parallel zur Normalen auf die Trägerfolie 10 angeordnet. Der LED-Chip 20 strahlt das UV-Licht seitlich aus der Lichtaustrittsfläche 21 in die Abstandsschicht 40 ein. Die Abstandsschicht 40 kann wie bei der in Figur 3 gezeigten Ausführungsform als eine Lichtleiterfolie ausgebildet sein, die das UV-Licht in Richtung der Farbreaktionsschicht 30 ablenkt beziehungsweise streut.

Es sei darauf hingewiesen, dass die Farbreaktionsschicht 30 bei den in den Figuren 3 und 4 gezeigten Ausführungsformen des Folienaufbaus anstelle auf dem Abschnitt 12 der Trägerfolie 10 beziehungsweise auf der Träger-/Deckfolie 60 auch auf einer Ober- oder Unterseite des Bereichs 13 der Trägerfolie 10 angeordnet sein kann. In diesem Fall ist die Abstandsschicht 40 derart ausgebildet, dass sie das eingestrahlte UV-Licht in Richtung des Abschnitts 13 der Trägerfolie 10 ablenkt beziehungsweise streut.

Der LED-Chip 20 kann mit Gleich- und Niederstrom betrieben werden. Dadurch muss keine komplexe Spannungswandlung oder Energiequelle genutzt werden. Zur Zuführung einer Spannung zu dem LED-Chip 20 kann bei den in den Figuren 1 bis 4 gezeigten Ausführungsformen des Folienaufbaus 1 eine elektrische Leiterbahn auf die Trägerfolie 10 aufgebracht sein. Dazu können sämtliche geeignete Druckverfahren, beispielsweise Sieb-, Flexo-, Tief-, InkJet- oder Tampon-Druck etc. verwendet werden.

Der LED-Chip 20 ist vorzugsweise mit einer Kontaktierung auf der der Lichtaustrittsfläche 21 gegenüber liegenden Seite ausgebildet. Mit Hilfe eines transparenten anisotropen Leitklebers kann auch ein konventioneller LED-Chip mit Kontaktierungen auf der Leuchtseite genutzt werden. Der LED-Chip 20 kann bei dieser Ausführungsform mittels des transparenten, anisotropen leitfähigen Klebstoffs auf die Trägerfolie aufgeklebt sein. Bei der in den Figuren 1 bis 4 dargestellten Ausführungsformen des Folienaufbaus ist ein anisotroper leitfähiger Klebstoff 70 auf der Rückseite des LED-Chips 20 aufgetragen, um den LED-Chip 20 auf die Trägerfolie 10 aufzukleben.

Die in den Figuren 1 bis 4 enthaltene Farbreaktionsschicht 30 kann zur Umwandlung des UV-Lichts beziehungsweise des Lichts im UV-nahen Bereich Phosphor enthalten. Durch Kombination von Phosphorschichten mit verschiedenen Emissionswellenlängen, das heißt durch Kombination verschiedener Phosphorfarben, in der Farbreaktionsschicht 30 können neue Mischfarben entstehen. Zusätzlich besteht die Möglichkeit, die Phosphorfarben mit anderen Farben, beispielsweise Tageslichtfarben oder opaken Farben, zu kombinieren, um wiederum neue Effekte zu erzielen. Mischfarben können somit auf unterschiedliche Art und Weise reguliert werden.

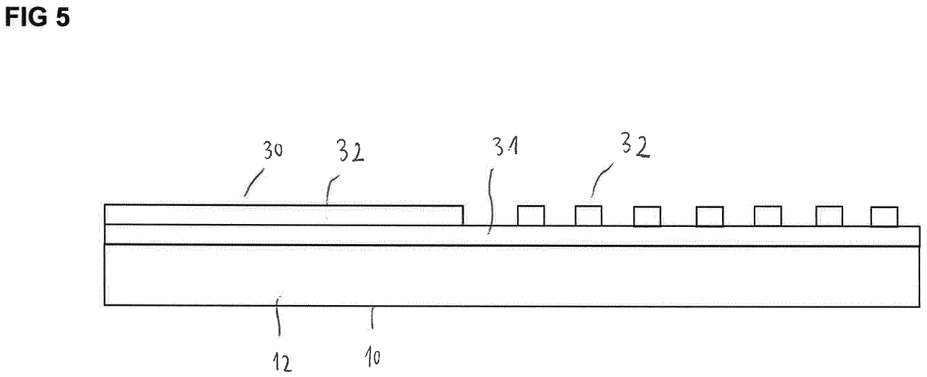

Die folgenden Figuren 5 bis 10 zeigen eine Teilansicht des Folienaufbaus 1. Dargestellt ist lediglich eine Teilansicht des gefalteten Folienaufbaus 1 der Figuren 1 und 3, bei dem die Farbreaktionsschicht 30 auf der Oberseite O12 des Abschnitts 12 der Trägerfolie 10 angeordnet ist. Die in den Figuren 5 bis 10 gezeigten Ausführungsformen des Folienaufbaus sind allerdings auch anwendbar auf die in den Figuren 2 und 4 gezeigten Ausgestaltungsformen des Folienaufbaus mit der separaten Träger-/Deckfolie 60. In diesen Fällen ist die in den Figuren 5 bis 10 gezeigte Farbreaktionsschicht 30 auf der Träger-/Deckfolie 60 angeordnet. Obwohl die Figuren 5 bis 10 die Farbreaktionsschicht 30 auf der Oberseite O12 des Abschnitts 12 der Trägerfolie 10 zeigen, kann die Farbreaktionsschicht bei den im Folgenden anhand der Figuren 5 bis 10 beschriebenen Ausführungsformen des Folienaufbaus auch auf der Unterseite U12 des Abschnitts 12 der Trägerfolie 10 oder auf der Unterseite U60 der Träger-/Deckfolie 60 angeordnet sein. Ebenso kann die Farbreaktionsschicht 30 für die im Folgenden beschriebenen Ausführungsformen der Figuren 5 bis 10 auch auf der Ober- beziehungsweise Unterseite des Abschnitts 13 der Trägerfolie 10 angeordnet sein.

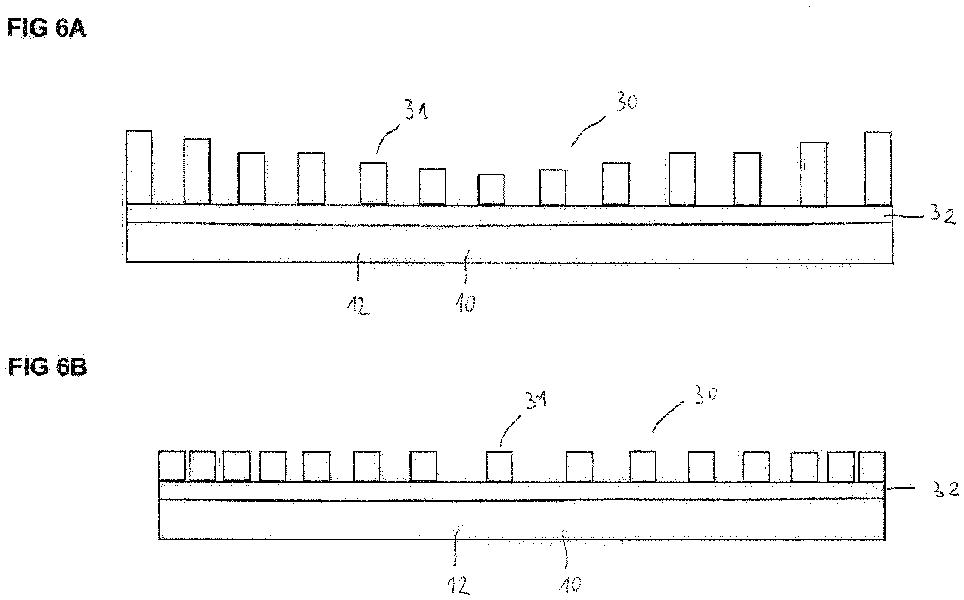

Die Figuren 5, 6A und 6B zeigen einen mehrlagigen, insbesondere einen zweilagigen Aufbau, der Farbreaktionsschicht 30. Die Farbreaktionsschicht 30 weist eine obere Lage 32, die auf einer unteren Lage 31 der Farbreaktionsschicht angeordnet ist, auf. Grundsätzlich kann die Farbreaktionsschicht 30 auch noch weitere Lagen aufweisen. In den in den Figuren 5, 6A und 6B dargestellten Ausführungsbeispielen verhindert die vollflächig auf der Trägerfolie 10 aufgedruckte Lage 31 der Farbreaktionsschicht 30, dass Licht im UV- beziehungsweise UV-nahen Bereich in die Umgebung des Folienaufbaus abgestrahlt wird. Bei dem mehrlagigen Folienaufbau kann die untere Lage 31 der Farbreaktionsschicht 30, auf die das von dem LED-Chip abgestrahlte UV-Licht zuerst auftritt, eine kleinere Emissionswellenlänge als die obere Lage 32 der Farbreaktionsschicht aufweisen. Die Lagen 31 und 32 der Farbreaktionsschicht 30 sind als Phosphorschichten ausgebildet.

Figur 5 zeigt eine Teilansicht einer Ausführungsform des Folienaufbaus 1 mit der Farbreaktionsschicht 30, die auf dem Abschnitt 12 der Trägerfolie 10 angeordnet ist. Die Farbreaktionsschicht 30 umfasst mindestens eine Lage 32, die komplett oder, wie in Figur 5 gezeigt, zumindest abschnittweise, als ein punkt- und/oder linienförmiges Raster aus Punkten und/oder Linien der Farbreaktionsschicht 30 ausgebildet ist. Die Lage 32 kann aber auch vollflächig oder, wie in Figur 5 gezeigt, abschnittweise vollflächig auf der Lage 31 der Farbreaktionsschicht 30 angeordnet sein.

Durch das Aufdrucken von Phosphorfarben übereinander können unterschiedliche Farbübergänge erzeugt werden. Weiterhin besteht die Möglichkeit, durch das Drucken von Lagen aus Phosphor mit unterschiedlicher Emissionswellenlänge in Form von Linien nebeneinander oder als Raster unterschiedliche Farbübergänge zu erzeugen. Die Lagen der Farbreaktionsschicht können auch in anderer Gestaltungsform, beispielsweise in Form von Rauten oder konzentrischen Kreisen, gedruckt sein. Die Lage 32 der Farbreaktionsschicht 30 weist eine Emissionswellenlänge auf, die größer ist als die Emissionswellenlänge der Lage 31 der Farbreaktionsschicht 30. Beispielsweise kann die mindestens eine weitere Lage 31 der Farbreaktionsschicht 30 eine Emissionswellenlänge von 515 nm und die mindestens eine Lage 32 der Farbreaktionsschicht 30 eine Emissionswellenlänge von 630 nm aufweisen.

Die Erzeugung einer Mischfarbe wird im Folgenden anhand eines Ausführungsbeispiels erläutert. Bei Verwendung einer Lage 31 aus Phosphor mit einer Emissionswellenlänge von 515 nm wird das einfallende UV-Licht in grünes Licht gewandelt. An denjenigen Bereichen der Farbreaktionsschicht 30, an denen über der Lage 31 Rasterpunkte beziehungsweise Rasterlinien der Lage 32 der Farbreaktionsschicht 30 angeordnet sind, wird das in die Lage 32 eingestrahlte grüne Licht von der Lage 32 der Farbreaktionsschicht 30 in rotes Licht gewandelt. Ein Betrachter hat somit aufgrund der Kombination des abgestrahlten grünen und roten Lichts den Eindruck einer gelb leuchtenden Fläche.

Die Leuchtstoffe kommen in einer Abstufung von 5 nm vor und können demnach fast jede beliebige Farbe erzeugen. Durch den geschickten Druck übereinander können somit mit nur wenigen Grundfarben viele verschiedene Farben erzeugt werden, und die Produktionskomplexität kann reduziert werden.

Die Figuren 6A und 6B zeigen eine Ausführungsform der Farbreaktionsschicht 30 mit einer vollflächig auf die Trägerfolie 10 aufgedruckten Lage 31 der Farbreaktionsschicht 30 und einer darüber angeordneten Lage 32 der Farbreaktionsschicht, die ein punkt- oder linienförmiges Raster aufweist. Bei der in Figur 6A gezeigten Ausführungsform variiert die Höhe der Punkte und/oder Linien der Lage 32. Bei der in Figur 6B gezeigten Ausführungsform variiert der Abstand der Punkte und/oder Linien der Lage 32 der Farbreaktionsschicht 30. Das punkt- und/oder linienförmige Raster der Farbreaktionsschicht 30 ist bei der in Figur 6A gezeigten Ausführungsform amplitudenmoduliert und bei der in Figur 6B gezeigten Ausführungsform frequenzmoduliert. Dadurch entsteht bei einem Betrachter der Eindruck, dass die Farbreaktionsschicht bei Anstrahlung mit UV-Licht unterschiedliche Farbübergänge aufweist.

Bei der in Figur 6A gezeigten Ausführungsform der Farbreaktionsschicht 30 nimmt die Höhe der Rasterpunkte/Rasterlinien ausgehend von einer Position im Zentrum über der Lichtaustrittsfläche 21 des LED-Chips zu beiden Rändern der Farbreaktionsschicht 30 zu. Bei der in Figur 6B gezeigten Ausführungsform ist das Raster frequenzmoduliert, indem die Rasterpunkte/Rasterlinien der Lage 32 der Farbreaktionsschicht 30 im Zentrum oberhalb der Lichtaustrittsfläche 21 des LED-Chips 20 einen großen Abstand aufweisen, der zu beiden Rändern der Farbreaktionsschicht 30 abnimmt. Dadurch entsteht bei einem Betrachter ein homogener Lichteindruck des abgestrahlten Lichts.

Eine weitere Möglichkeit zur Erzeugung von Farbübergängen besteht darin, die Dicke des Farbauftrags, mit der die Farbreaktionsschicht 30 auf die Trägerfolie 10 beziehungsweise die Träger-/Deckfolie 60 aufgetragen wird, zu verändern. Die Farbdicke kann beispielsweise durch die Anzahl der Druckdurchgänge oder durch die Wahl der Druckform verändert werden.

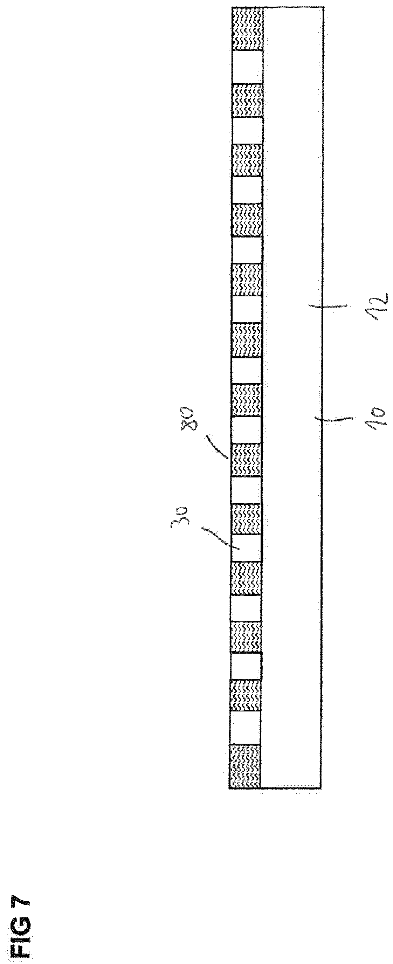

Des Weiteren besteht die Möglichkeit, die Phosphorfarbe der Farbreaktionsschicht 30 und eine opake Farbe insgesamt im Rasterdruck zu verdrucken. Figur 7 zeigt eine Ausgestaltungsform des Folienaufbaus, bei dem die Farbreaktionsschicht 30 als ein punkt- und/oder linienförmiges Raster ausgestaltet ist. Das Raster kann verschiedene Phosphorfarben enthalten. Um zu verhindern, dass Licht aus dem UV- beziehungsweise UV-nahen Bereich in die Umgebung abgestrahlt wird, ist zwischen den Punkten und/oder Linien des Rasters der Farbreaktionsschicht 30 eine opake Farbe 80 eingedruckt.

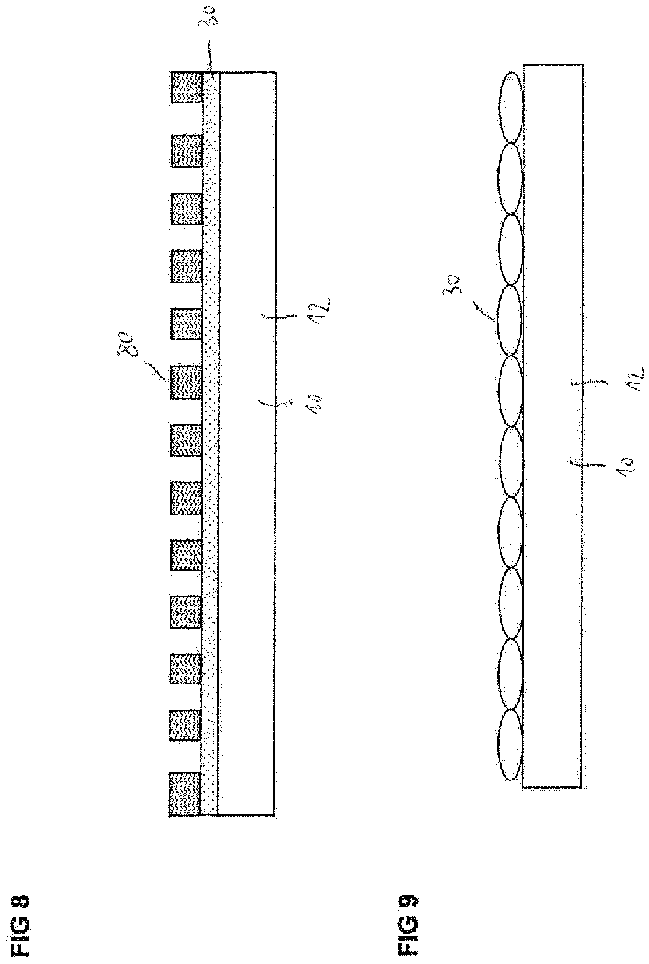

Figur 8 zeigt eine weitere Ausgestaltungsform des Folienaufbaus 1, bei dem die Farbreaktionsschicht 30 vollflächig auf die Trägerfolie 10 aufgedruckt ist. Auf der vollflächig gedruckten Lage der Farbreaktionsschicht 30 ist im Rasterdruck eine opake Farbe 80 aufgedruckt. Eine Homogenisierung des von dem LED-Chip 20 abgestrahlten Lichts kann bei einer derartigen Ausführungsform beispielsweise dadurch erreicht werden, indem die opake Farbe über der Lichtaustrittsfläche des LED-Chips vollflächig beziehungsweise mit geringem Abstand zwischen den Punkten und/oder Linien des Rasters auf die Farbreaktionsschicht 30 aufgedruckt wird und der Punkt- und/oder Linienabstand der opaken Farbe 80 mit zunehmendem Abstand von der Lichtaustrittsfläche des LED-Chips zum Rand der Farbreaktionsschicht 30 hin zunimmt.

Um ein bestimmtes Motiv innerhalb der Farbreaktionsschicht 30 zu erzeugen, das bei rückseitiger Anstrahlung mit dem von dem LED-Chip ausgesandten Licht leuchtet, kann das Motiv beispielsweise direkt mit einer Phosphorfarbe in der Farbreaktionsschicht 30 gedruckt werden. Diejenigen Stellen, die nicht leuchten sollen, können mit einer opaken Farbe bedruckt werden.

Um die Lichtstreuung und Lichtintensität zu beeinflussen und gegebenenfalls zu homogenisieren, können verschiedene Druckmethoden angewandt werden. Beispielsweise kann die Farbreaktionsschicht 30 auf die Trägerfolie 10 beziehungsweise die Träger-/Deckfolie 60 im Rasterdruck in Form von Punkten und/oder Linien aufgedruckt werden, wobei die Farbreaktionsschicht 30 Phosphorfarben mit verschiedenen Opazitäten aufweist.

Gemäß einer weiteren Ausführungsform kann die Profilform des Rasters geändert werden. Ausgehend von runden Profilen kann sich die Form der Rasterpunkte in konzentrischen Kreisen ändern und beispielsweise in quadratförmige Punkte überführt werden. Je nach Veränderung der Profilform ist es somit möglich, einen Intensitätsausgleich des von dem LED-Chip abgestrahlten Lichts innerhalb der Farbreaktionsschicht 30 von innen, das heißt über der Lichtaustrittsfläche des LED-Chips, nach außen, das heißt zu den weiter entfernt von der Lichtaustrittsfläche des LED-Chips liegenden Rändern der Farbreaktionsschicht, zu erzielen.

Eine weitere Möglichkeit zur Schaffung eines Intensitätsausgleichs des abgestrahlten Lichts beziehungsweise zur Homogenisierung des abgestrahlten Lichts besteht darin, den Phosphoranteil in der Farbreaktionsschicht 30 ortsabhängig zu variieren. Beispielsweise können diejenigen Bereiche der Farbreaktionsschicht 30, die unmittelbar über der Lichtaustrittsfläche 21 des LED-Chips 20 angeordnet sind, einen geringeren Phosphoranteil als diejenigen Bereiche der Farbreaktionsschicht 30, die an den Rändern der Farbreaktionsschicht 30 weiter entfernt von der Lichtaustrittsfläche 21 des LED-Chips liegen, aufweisen.

Eine weitere Möglichkeit, die Intensität des abgestrahlten Lichts zu verändern, besteht darin, über der Farbreaktionsschicht 30 eine weitere Farbschicht als "Dämpfungsfarbe" aufzudrucken. In einem solchen Fall kann zum Beispiel die Farbreaktionsschicht 30 zunächst vollflächig auf dem Abschnitt 12 der Trägerfolie 10 beziehungsweise auf die Träger-/Deckfolie 60 aufgetragen sein. Über der Farbreaktionsschicht 30 ist dann eine weitere Farbschicht als "Dämpfungsfarbe" im Rasterdruck aufgedruckt. Um das mit hoher Intensität unmittelbar über der Lichtaustrittsfläche des LED-Chips austretende Licht abzudämpfen, kann die weitere Farbschicht an den Abschnitten der Farbreaktionsschicht 30, die in Projektion senkrecht über der Lichtaustrittsfläche des LED-Chips angeordnet sind, vollflächig oder mit engem Rasterabstand aufgetragen beziehungsweise aufgedruckt werden. Der Rasterabstand, mit dem die weitere Farbschicht über der Farbreaktionsschicht aufgetragen ist, nimmt dann von innen nach außen zu den Rändern der Farbreaktionsschicht zu. Die Dämpfungsfarbe wirkt bei dieser Ausführungsform als ein Farbfilter, sodass das von der LED abgestrahlte Licht in seiner Intensität verändert werden kann.

Zur Erzielung von höheren Auflösungen des punkt- oder linienförmigen Rasters besteht die Möglichkeit, die im Rasterdruck aufgedruckte Farbe der Farbreaktionsschicht 30, eine opake Farbe, eine "Dämpfungsfarbe" oder einer weitere Farbschicht mittels eines Lasers nachzubearbeiten.

Gemäß einer weiteren Ausgestaltungsform des Folienaufbaus können die einzelnen Rasterpunkte der Farbreaktionsschicht 30 als linsenförmige Farbtropfen ausgestaltet sein. Die Farbtropfen wirken somit als "Mikrolinsen" und verändern das von dem LED-Chip abgestrahlte Licht. Figur 9 zeigt zur Illustration dieser Ausgestaltungsform beispielhaft den Abschnitt 12 der Trägerfolie 10 mit der darüber in Form von linsenförmigen Farbtropfen angeordneten Farbreaktionsschicht 30. Die linsenförmigen Farbtropfen können beispielsweise im Inkjet-Verfahren gedruckt werden. Die Linsenform und -größe kann durch veränderbare Oberflächenspannung der Tinte beziehungsweise Farbe einstellbar sein. Die Schichtdicke der Farbreaktionsschicht 30 beziehungsweise der Rasterabstand kann durch Verändern der Größe und der Anzahl der Farbtropfen mit Hilfe des Inkjet-Verfahrens variiert werden.

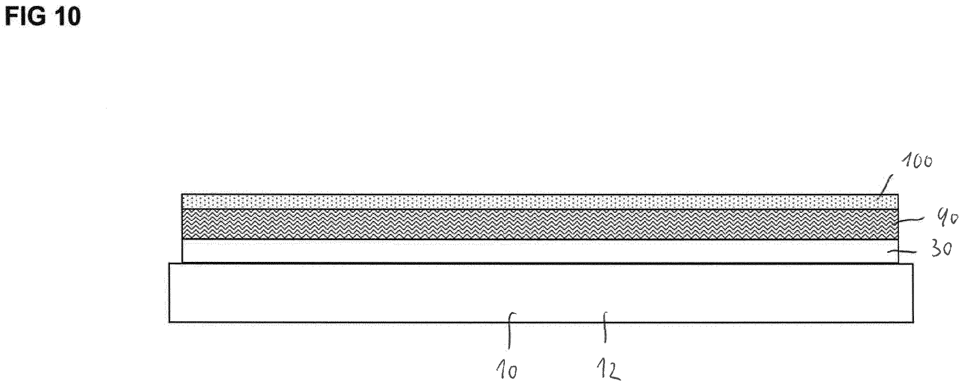

Figur 10 zeigt eine Ausführungsform des Folienaufbaus 1 in einer Teilansicht mit dem Abschnitt 12 der Trägerfolie 10, auf dem die Farbreaktionsschicht 30 aufgetragen ist. Über der Farbreaktionsschicht 30 ist eine UV-Licht sperrende Schicht 90 und optional eine zusätzliche Farbschicht 100 aus einer sichtbaren Farbe angeordnet ist. Die UV-Licht sperrende Schicht verhindert, dass beispielsweise ein Motiv, das in der Farbreaktionsschicht 30 integriert ist, für einen Betrachter bereits sichtbar ist, wenn die Farbreaktionsschicht 30 nicht von dem Licht des LED-Chips sondern nur von dem Umgebungslicht angestrahlt wird. Bei Umgebungslicht sieht ein Betrachter stattdessen lediglich die über der UV-Licht sperrenden Schicht 90 angeordnete Farbschicht 100 aus der sichtbaren Farbe. Im Fall einer weißen Farbschicht 100 sieht der Betrachter somit vor dem Einschalten der LED nur eine weiße Farbfläche. Erst bei Hinterleuchtung der Farbreaktionsschicht 30 mit dem von dem LED-Chip abgestrahlten Licht wird ein Motiv innerhalb der Farbreaktionsschicht 30 sichtbar.

Gemäß einer weiteren Ausführungsform besteht die Möglichkeit der Durchführung einer partiellen Abschattung - elektrisch ansteuerbar - um mehr als ein Symbol an einer Stelle innerhalb der Farbreaktionsschicht 30 anzeigen zu können.

Im Folgenden werden "mechanische" Möglichkeiten der Lichtleitung beziehungsweise - streuung aufgeführt.

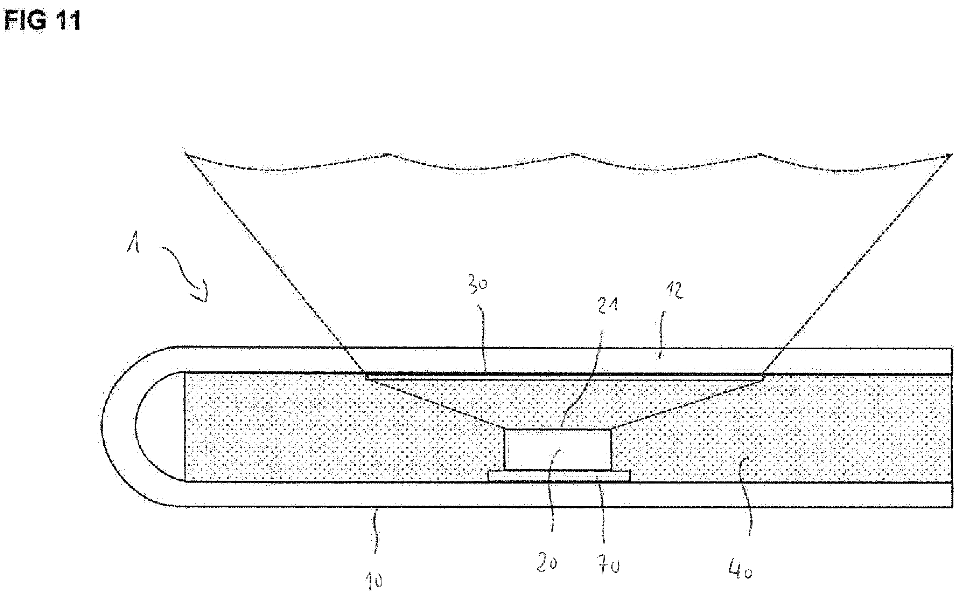

Figur 11 zeigt eine Ausführungsform des Folienaufbaus 1, bei der zwischen der Lichtaustrittsfläche 21 des LED-Chips 20 und der Farbreaktionsschicht 30 eine Abstandsschicht 40 angeordnet ist, um den Abstand zwischen der Lichtaustrittsfläche 21 und der Farbreaktionsschicht 30 zu beeinflussen. Die Abstandsschicht 40 kann auch, wie bei der in den Figuren 3 und 4 gezeigten Ausführungsform des Folienaufbaus mit Kantenstrahler, zwischen dem Abschnitt 13 der Trägerfolie 10 und dem Abschnitt 12 der Trägerfolie 10 beziehungsweise zwischen dem Abschnitt 13 der Trägerfolie 10 und der Träger-/Deckfolie 60 angeordnet sein.

Die Abstandsschicht 40 kann als ein gedruckter Lichtleiter ausgebildet sein. Die Abstandsschicht 40 kann gemäß einer weiteren Ausführungsform als eine lichtleitende Folie mit oder ohne Prismen, als eine lichtleitende Folie mit Streueffekten oder als eine lichtleitende, mattierte Folie ("Milchglasfolie") ausgebildet sein. Die optischen Eigenschaften der Abstandsfolie 40 können mittels eines Laser beeinflusst werden. Beispielsweise kann somit eine digitale, ortsabhängige Mattierung der Folie erzeugt werden. Des Weiteren besteht die Möglichkeit, Motive, beispielsweise 3D-Motive, in die Abstandsfolie einzuprägen.

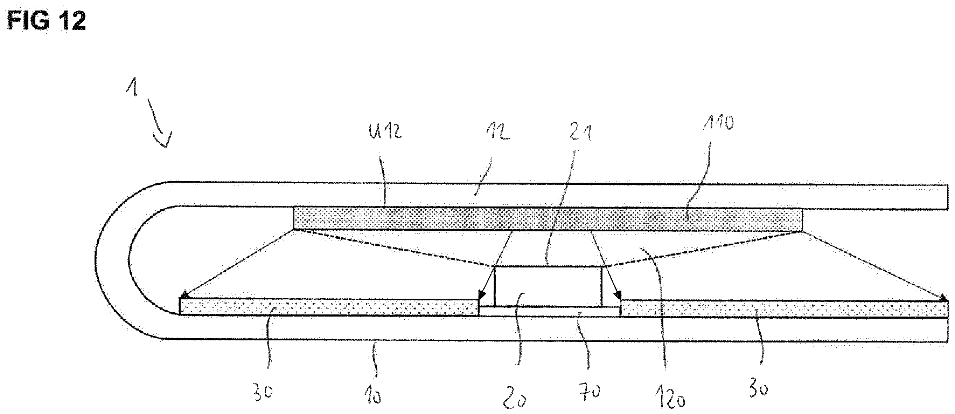

Figur 12 zeigt eine Ausführungsform des Folienaufbaus 1 am Beispiel des Folienaufbaus mit umgefalteter Trägerfolie. Stattdessen kann der Folienaufbau auch eine separate Träger-/Deckfolie 60 aufweisen. Der der LED-Chip 20 strahlt Licht in Richtung des Abschnitts 12 der Trägerfolie 10 beziehungsweise in Richtung der Träger-/Deckfolie 60 ab. Je nach Ausführungsform ist die Unterseite U12 des Abschnitts 12 der Trägerfolie 10 oder die Unterseite U60 der Träger-/Deckfolie 60 mit einer Reflektorschicht 110 beschichtet. Die Farbreaktionsschicht 30 ist auf der Trägerfolie 10 neben dem LED-Chip 20 angeordnet. Die Reflektorschicht 110 ist dazu ausgebildet, das an der Reflektorschicht 110 reflektierte UV-Licht des LED-Chips in Richtung der Farbreaktionsschicht 30 zu streuen. Die Reflektorschicht 110 kann beispielsweise als eine Aluminiumfolie oder als eine Schicht aus Glaskugeln ausgebildet sein. Durch eine derartige Ausgestaltungsform des Folienaufbaus wird eine größere Streubreite des LED-Chips erreicht und die Lichtausbeute kann verbessert werden.

### Bezugszeichenliste

- 1: Folienaufbau
- 10: Trägerfolie
- 20: LED-Chip
- 30: Farbreaktionsschicht
- 40: Abstandsschicht
- 50: Klebeschicht
- 60: Träger-/Deckfolie
- 70: Klebstoff
- 80: opake Farbe
- 90: UV-Licht sperrende Schicht
- 100: Farbschicht
- 110: Reflektorschicht

## Patentansprüche

1. Folienaufbau mit Erzeugen von sichtbarem Licht mittels LED-Technologie, umfassend:
- eine Trägerfolie (10),
- einen LED-Chip (20) zum Erzeugen von UV-Licht, wobei der LED-Chip (20) auf der Trägerfolie (10) angeordnet ist und eine Lichtaustrittsfläche (21) zum Abstrahlen des UV-Lichts aufweist,
- eine Farbreaktionsschicht (30) zum Umwandeln des UV-Lichts in das sichtbare Licht,
- wobei die Farbreaktionsschicht (30) über dem LED-Chip (20) oder seitlich versetzt zu dem LED-Chip (20) angeordnet ist,
- wobei die Farbreaktionsschicht (30) eine Strukturierung aufweist, so dass das aus der Lichtaustrittsfläche (21) des LED-Chips (20) abgestrahlte UV-Licht nicht in die Umgebung des Folienaufbaus (1) abgestrahlt wird.

2. Folienaufbau nach Anspruch 1,
- wobei der LED-Chip (20) auf einem ersten Abschnitt (11) der Trägerfolie (10) angeordnet ist,
- wobei die Farbreaktionsschicht (30) auf einem zweiten Abschnitt (12) der Trägerfolie (10) angeordnet ist,
- wobei die Trägerfolie (10) derart umgefaltet ist, so dass der zweite Abschnitt (12) der Trägerfolie (10) über dem ersten Abschnitt (11) der Trägerfolie angeordnet ist.

3. Folienaufbau nach Anspruch 1, umfassend:
- eine weitere Trägerfolie (60), auf der die Farbreaktionsschicht (30) angeordnet ist,
- wobei die weitere Trägerfolie (60) derart über der Trägerfolie (10) mit dem LED-Chip (20) angeordnet ist, dass die Farbreaktionsschicht (30) über dem LED-Chip (20) oder seitlich versetzt zu dem LED-Chip (20) angeordnet ist.

4. Folienaufbau nach Anspruch 3, umfassend:
- eine Abstandsschicht (40),
- wobei der LED-Chip (20) als ein Kantenstrahler ausgebildet ist, der das aus der Lichtaustrittsfläche (21) abgestrahlte Licht in die Abstandsschicht (40) einstrahlt,
- wobei zwischen dem ersten und zweiten Abschnitt (11, 12) der Trägerfolie ein dritter Abschnitt (13) der Trägerfolie angeordnet ist,
- wobei die Abstandsschicht (40) zwischen dem zweiten und dritten Abschnitt (12, 13) der Trägerfolie (10) angeordnet ist.

5. Folienaufbau nach einem der Ansprüche 1 bis 4,
wobei die Farbreaktionsschicht (30) mindestens eine Lage (32), die als ein punkt- und/oder linienförmiges Raster aus Punkten und/oder Linien der Farbreaktionsschicht (30) ausgebildet ist, aufweist.

6. Folienaufbau nach Anspruch 5,
wobei die mindestens eine Lage (32) des punkt- oder linienförmigen Rasters der Farbreaktionsschicht (30) in Bezug auf die jeweilige Höhe der Punkte oder Linien und/oder in Bezug auf den jeweiligen Abstand der Punkte und/oder Linien variiert.

7. Folienaufbau nach einem der Ansprüche 5 oder 6,
wobei die mindestens eine Lage (32) des punkt- oder linienförmigen Rasters der Farbreaktionsschicht (30) Phosphorfarben mit verschiedenen Opazitäten aufweist.

8. Folienaufbau nach einem der Ansprüche 5 bis 7,
- wobei die Farbreaktionsschicht (30) mindestens eine weitere Lage (31), die vollflächig auf dem zweiten Abschnitt (12) der Trägerfolie (10) oder auf der weiteren Trägerfolie (60) angeordnet ist, aufweist,
- wobei die mindestens eine Lage (32) der Farbreaktionsschicht (30) mit dem punkt- oder linienförmigen Raster auf der mindestens einen weiteren Lage (31) der Farbreaktionsschicht (30) angeordnet ist.

9. Folienaufbau nach einem der Ansprüche 5 bis 8,
wobei in Bereichen zwischen den Punkten und/oder Linien des punkt- und/oder linienförmigen Rasters der mindestens einen Lage (32) der Farbreaktionsschicht (30) eine opake Farbschicht (80) angeordnet ist.

10. Folienaufbau nach einem der Ansprüche 3 bis 8,
- wobei die Farbreaktionsschicht (30) vollflächig auf der Trägerfolie (30) oder auf der weiteren Trägerfolie (60) angeordnet ist,
- wobei über der Farbreaktionsschicht (30) ein punkt- und/oder linienförmiges Raster aus Punkten und/oder Linien einer opaken Farbe (80) angeordnet ist.

11. Folienaufbau nach einem der Ansprüche 1 bis 10,
wobei die Farbreaktionsschicht (30) Phosphor enthält und der Phosphoranteil in der Farbreaktionsschicht (30) ortsabhängig variiert.

12. Folienaufbau nach einem der Ansprüche 1 bis 11,
wobei über der Farbreaktionsschicht (30) eine UV-Licht sperrende Schicht (90) und/oder eine Farbschicht (100) aus einer sichtbaren Farbe angeordnet ist.

13. Folienaufbau nach einem der Ansprüche 1 bis 12,
wobei die Farbreaktionsschicht (30) linsenförmige Farbtropfen aufweist.

14. Folienaufbau nach einem der Ansprüche 1 bis 13,
wobei die Abstandsschicht (40) als eine lichtleitende Folie mit Prismen oder als eine lichtleitende Folie mit Streueffekten oder als eine lichtleitende mattierte Folie ausgebildet ist.

15. Folienaufbau nach einem der Ansprüche 1 bis 14,
- wobei der zweite Abschnitt (12) der Trägerfolie (10) oder die weitere Trägerfolie (60) mit einer Reflektorschicht (110) beschichtet ist,
- wobei die Farbreaktionsschicht (30) auf der Trägerfolie (10) angeordnet ist,
- wobei die Reflektorschicht (110) dazu ausgebildet ist, das an der Reflektorschicht (110) reflektierte UV-Licht des LED-Chips (20) in Richtung der Farbreaktionsschicht (30) zu streuen.
